Europäisches Patentamt

European Patent Office

Office européen des brevets

(11) Veröffentlichungsnummer: **0 286 814**
**A2**

## (12) EUROPÄISCHE PATENTANMELDUNG

(21) Anmeldenummer: 88103016.7

(22) Anmeldetag: 29.02.88

(51) Int. Cl.⁴: **G01R 31/28** , **G01R 31/02** , **H03K 17/78**

(30) Priorität: 31.03.87 DE 3710597

(43) Veröffentlichungstag der Anmeldung:
19.10.88 Patentblatt 88/42

(84) Benannte Vertragsstaaten:
AT BE CH DE FR GB IT LI NL

(71) Anmelder: **Siemens Aktiengesellschaft Berlin und München**
**Wittelsbacherplatz 2**
**D-8000 München 2(DE)**

(72) Erfinder: **Doemens, Günter, Dr.-Ing.**
**Eichenfeldstrasse 4**
**D-8150 Holzkirchen(DE)**

(54) Ansteuereinrichtung.

(57) Es soll mit relativ geringem Aufwand eine Einrichtung zur zuverlässigen Ansteuerung einer Vielzahl von Leitungen (L1...Ln) oder einer Vielzahl von Kontaktstellen (K) geschaffen werden.

Zur Ansteuerung mindestens zweier von mehreren Leitungen (L1...Ln) sind mindestens zwei Ansteuerleitungen (A1, A2) jeweils über einen Photowiderstand (Pw) mit jeder Leitung (L1... Ln) verbunden, wobei jeder Photowiderstand (Pw) vorzugsweise über einen ablenkbaren Strahl steuerbar mit Licht beaufschlagbar ist. Die Selektion erfolgt somit dadurch, daß die angesteuerten Photowiderstände (Pw) niederohmig werden. Zur Ansteuerung mindestens zweier von mehreren rasterförmig angeordneten Kontaktstellen (K) sind diese dann jeweils über einen Photowiderstand (Pw) mit den zugeordneten Leitungen (L1...Ln) verbunden.

Die erfindungsgemäßen Einrichtungen werden vorzugsweise für die elektrische Funktionsprüfung von Leiterplatten eingesetzt.

FIG 2

## Ansteuereinrichtung

Die Erfindung betrifft eine Einrichtung zur Ansteuerung mindestens zweier von mehreren Leitungen und eine Einrichtung zur Ansteuerung mindestens zweier von mehreren rasterförmig angeordneten Kontaktstellen.

In Prüfautomaten und Prüfadaptern für unbestückte und bestückte Leiterplatten sowie für Verdrahtungsfelder in Löt-oder Crimptechnik wird die Kontaktierung der ausgewählten Meßstellen in der Regel über federnde Prüfspitzen vorgenommen. Die entsprechend dem Rastermaß eines zu prüfenden Verdrahtungsfeldes angeordneten federnden Prüfspitzen werden mittels Federhülsen befestigt, die in eine Trägerplatte eingepreßt sind und in die man die Prüfspitzen einschiebt (Elektronik Produktion & Prüftechnik, November 1979, Seiten 472 und 473).

Aus der EP-A-0 102 565 ist eine Vorrichtung für die elektrische Funktionsprüfung von Verdrahtungsfedern bekannt, bei welcher die bisher übliche ohm'sche Kontaktierung der Meßstellen durch eine berührungslose ionische Kontaktierung über Gasentladungsstrecken ersetzt wird. Hierzu wird in eine auf die Verdrahtungsfelder aufsetzbare Trägerplatte eine Vielzahl von mit Elektroden versehenen Gasentladungskanälen eingebracht, wobei die im Rahmen der Verdrahtungsfelder angeordneten Gasentladungskanäle zu den Meßstellen hin offen sind. Sind nun zwei ausgewählte Meßstellen beispielsweise durch eine Leiterbahn elektrisch leitend miteinander verbunden, so bilden die zugeordneten Gasentladungskanäle zwei in Reihe geschaltete Gasentladungsstrecken, die durch Anlegen einer hinreichend hohen Spannung an die Elektroden gezündet werden können. Mit der Zündung der Gasentladungen erfolgt dann ein Stromtransport, der zu Prüfzwecken ausgewertet werden kann. Unterbleibt die Zündung der Gasentladungen oder fließt nach einer Zündung ein zu geringer Strom, so kann auf eine unterbrochene oder von vornerein nicht existierende elektrisch leitende Verbindung zwischen den ausgewählten Meßstellen geschlossen werden. Wird der an die Elektroden angelegten Spannung eine Wechselspannung überlagert, so kann die daraus resultierende Stromänderung phasenempfindlich zur angelegten Wechselspannung gemessen und für die Bestimmung des Widerstandes einer zwischen den ausgewählten Meßstellen bestehenden Verbindung herangezogen werden. Die bekannte Vorrichtung ermöglicht also Leitfähigkeits-und Isolationsmessungen, wobei durch das Vermeiden von ohm'schen Kontakten eine sehr hohe Zuverlässigkeit erreicht wird.

In Prüfautomaten und Prüfadaptern für unbestückte und bestückte Leiterplatten sowie für Verdrahtungsfelder in Löt-oder Crimptechnik kann die Anzahl der Meßstellen beispielsweise Hunderttausend betragen. Mit der Anzahl der Meßstellen steigt dann sowohl beim Einsatz federnder Prüfspitzen als auch bei der ionischen Kontaktierung über Gasentladungsstrecken die Anzahl der erforderlichen Zuleitungen und Schaltelemente, wodurch ein erheblicher gerätetechnischer Aufwand und entsprechend hohe Kosten verursacht werden.

Der Erfindung liegt die Aufgabe zugrunde, eine Einrichtung zur Ansteuerung mindestens zweier von mehreren Leitungen oder rasterförmig angeordneten Kontaktstellen zu schaffen, die mit relativ geringem Aufwand eine zuverlässige Ansteuerung einer Vielzahl von Leitungen oder Kontaktstellen ermöglicht.

Diese Aufgabe wird bei einer Einrichtung zur Ansteuerung mindestens zweier von mehreren Leitungen erfindungsgemäß dadurch gelöst, daß mindestens zwei Ansteuerleitungen jeweils über einen Photowiderstand mit jeder Leitung verbunden sind und daß jeder Photowiderstand steuerbar mit Licht beaufschlagbar ist.

Bei einer Einrichtung zur Ansteuerung mindestens zweier von mehreren rasterförmig angeordneten Kontaktstellen wird die Aufgabe erfindungsgemäß dadurch gelöst, daß die Kontaktstellen reihenweise über jeweils einen zugeordneten Photowiderstand mit zugeordneten Leitungen verbunden sind, daß mindestens zwei Ansteuerleitungen jeweils über einen Photowiderstand mit jeder Leitung verbunden sind und daß jeder Photowiderstand steuerbar mit Licht beaufschlagbar ist.

Den beiden vorstehend angegebenen Lösungen liegt die allgemeine erfinderische Idee zugrunde, daß die Ansteuerung von Leitungen oder Kontaktstellen durch den Einsatz von steuerbar mit Licht beaufschlagbaren Widerständen erheblich vereinfacht werden kann. Es entsteht eine Art "optischer Multiplexer", dessen Vorzüge insbesondere durch die flexible und einfach zu realisierende Lichtbeaufschlagung bedingt sind. So genügen beispielsweise zwei Ansteuerleitungen um zwei Kontaktstellen einer Vielzahl von Kontaktstellen sicher anzusteuern.

Gemäß einer bevorzugten Ausgestaltung der Erfindung bestehen die Photowiderstände aus Cadmiumsulfid oder Cadmiumselenid. Photowiderstände aus diesen photoleitenden Materialien zeichnen sich durch erhebliche Leitfähigkeiterhöhungen bei Lichteinstrahlung aus.

Vorzugsweise sind die Photowiderstände in Dünnfilmtechnik hergestellt, d.h. es kann auf Techniken zurückgegriffen werden, die sich bei der Herstellung von Schichtschaltungen bereits bewährt haben. Diese Vorteile ergeben sich dann auch bei der Herstellung der Ansteuerleitungen oder der Leitungen in Dünnfilmtechnik.

Die steuerbare Beaufschlagung der Photowiderstände mit Licht kann beispielsweise durch unmittelbar darüber angeordnete Masken vorgenommen werden, deren gegebenenfalls steuerbare Öffnungen das Licht einer Lichtquelle nur an den gewünschten Stellen durchlassen. Die Abbildung der jeweiligen Löcher einer Maske auf die ausgewählten Photowiderstände ist ebenfalls möglich. Gemäß einer besonders bevorzugten Ausgestaltung der Erfindung ist jedoch vorgesehen, daß die Photowiderstände über einen ablenkbaren Strahl mit Licht beaufschlagbar sind. Dabei hat es sich im Hinblick auf die erwünschte Leitfähigkeitserhöhung als besonders günstig erwiesen, wenn der Strahl durch einen fokussierbaren Laserstrahl gebildet ist.

Gemäß einer weiteren bevorzugten Ausgestaltung der Erfindung ist zur Ablenkung des Strahls ein akusto-optischer Ablenker vorgesehen, der sich durch besonders geringe Positionierzeiten auszeichnet.

Bei entsprechend geringen Positionierzeiten des ablenkbaren Strahls können die Photowiderstände dann auch seriell mit Licht beaufschlagt werden. Dies wird durch eine gegenüber der Rekombinationszeit bzw. Abklingzeit der Photowiderstände kleine Positionierzeit ermöglicht. Die steuerbare Lichtbeaufschlagung kann dann beispielsweise über einen einzigen Laser vorgenommen werden, wodurch sich eine weitere erhebliche Reduzierung des gerätetechnischen Aufwandes ergibt.

Ausführungsbeispiele der Erfindung sind in der Zeichnung dargestellt und werden im folgenden näher beschrieben.

Es zeigen

Fig. 1 das Grundprinzip einer Einrichtung zur Ansteuerung zweier von mehreren Leitungen,

Fig. 2 das Grundprinzip einer Einrichtung zur Ansteuerung zweier von mehreren rasterförmig angeordneten Kontaktstellen,

Fig. 3 den Einsatz einer Einrichtung gemäß Fig. 2 bei der elektrischen Funktionsprüfung von Leiterplatten und

Fig. 4 eine perspektivische Gesamtdarstellung der in den Figuren 2 und 3 aufgezeigten Einrichtung.

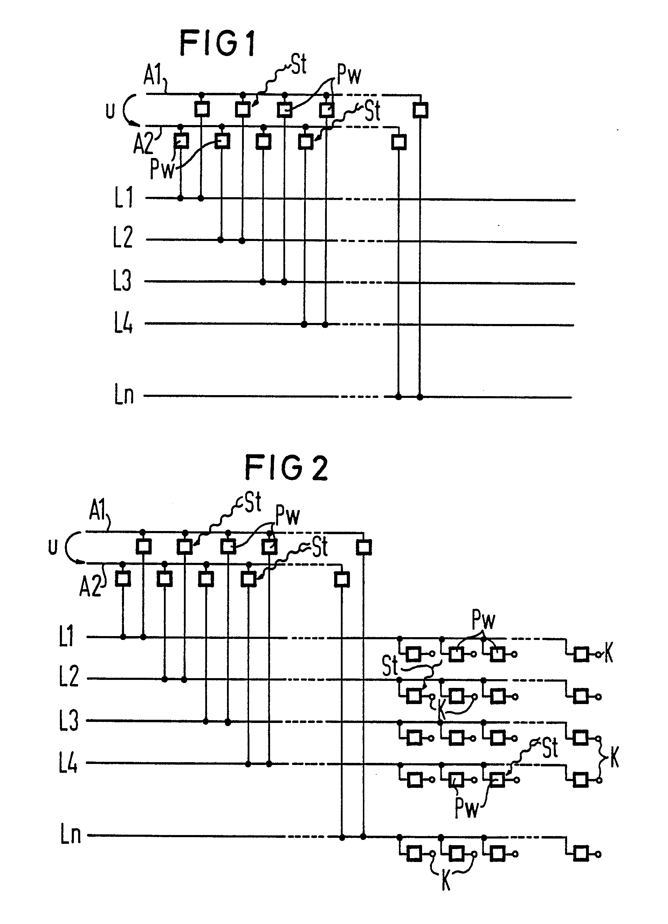

Fig. 1 zeigt in stark vereinfachter schematischer Darstellung eine Einrichtung zur Ansteuerung zweier von mehreren Leitungen L1, L2, L3, L4 usw. bis Ln über zwei mit A1 und A2 bezeichnete Ansteuerleitungen. Es ist zu erkennen, daß jede der beiden Ansteuerleitungen A1 und A2 jeweils über einen separaten Photowiderstand Pw mit jeder der Leitungen L1 bis Ln verbunden ist. Sind diese Photowiderstände Pw nicht beleuchtet, so tritt aufgrund ihres hohen elektrischen Widerstandes eine an den Ansteuerleitungen A1 und A2 angelegte Spannung U an den Leitungen L1 bis Ln praktisch nicht in Erscheinung. Die Selektion der Leitungen L1 bis Ln erfolgt durch die lokale Lichtbeaufschlagung der zugeordneten Photowiderstände Pw mit einem ablenkbaren Strahl St, bei welchem es sich um einen fokussierbaren Laserstrahl handelt. Die ausgewählten Photowiderstände Pw werden dann niederohmig, so daß in den beiden zugeordneten Leitungen L1 bis Ln ein für den jeweiligen Zweck hinreichender Strom fließen kann. Die Beaufschlagung der den ausgewählten Leitungen L1 bis Ln zugeordneten Photowiderstände Pw erfolgt seriell über einen einzigen Strahl St bzw. einen einzigen Laser, da die Positionierzeit bei Verwendung eines akusto-optischen Ablenkers klein gegenüber der Rekombinationszeit bzw. Abklingzeit der aus Cadmiumsulfid oder Cadmiumselenid bestehenden Photowiderstände Pw ist.

Bei dem in Fig. 1 dargestellten Beispiel werden der der Ansteuerleitung A1 und der Leitung L2 zugeordnete Photowiderstand Pw und der der Ansteuerleitung A2 und der Leitung L4 zugeordnete Photowiderstand Pw nacheinander durch den ablenkbaren Strahl St mit Licht beaufschlagt. Somit sind im dargestellten Fall die Leitungen L2 und L4 angesteuert bzw. mit den Ansteuerleitungen A1 bzw. A2 niederohmig verbunden.

Fig. 2 zeigt in stark vereinfachter schematischer Darstellung eine Einrichtung zur Ansteuerung zweier von mehreren rasterförmig angeordneten Kontaktstellen K über zwei wiederum mit A1 und A2 bezeichnete Ansteuerleitungen. Diese beiden Ansteuerleitungen A1 und A2 sind wie bei der Einrichtung nach Fig. 1 jeweils über einen separaten Photowiderstand Pw mit jeder der Leitungen L1 bis Ln verbunden. Andererseits ist jede der Leitungen L1 bis Ln einer Zeile der rasterförmig angeordneten Kontaktstellen K zugeordnet, wobei jede Kontaktstelle K über einen Photowiderstand Pw mit der zugeordneten Leitung L1 bis Ln verbunden ist. Die Selektion der Kontaktstellen K erfolgt durch die lokale Lichtbeaufschlagung der zugeordneten Photowiderstände Pw zwischen den Ansteuerleitungen A1 bzw. A2 und den Leitungen L1 bis Ln sowie der zugeordneten Photowiderstände Pw zwischen den Leitungen L1 bis Ln und den ausgewählten Kontaktstellen K mit einem ablenkbaren Strahl St, bei welchem es sich wieder um einen fokussierbaren Laserstrahl handelt. Die vier mit Licht beaufschlagten Photowiderstände Pw werden dann niederohmig so daß jede Ansteuerleitung A1 bzw. A2 niederohmig mit einer der beiden ausgewählten Kontaktstellen K verbunden ist.

Bei dem in Fig. 2 dargestellten Beispiel werden - der der Ansteuerleitung A1 und der Leitung L2 zugeordnete Photowiderstand Pw,
- der der Ansteuerleitung A2 und der Leitung L4 zugeordnete Photowiderstand Pw,
- der der Leitung L2 in der ersten Spalte zugeordnete Photowiderstand Pw und
- der der Leitung L4 in der dritten Spalte zugeordnete Photowiderstand Pw

seriell, d.h. kurz nacheinander durch den ablenkbaren Strahl St mit Licht beaufschlagt. Somit sind im dargestellten Fall die Kontaktstelle K der zweiten Zeile und der ersten Spalte und die Kontaktstelle K der vierten Zeile und der dritten Spalte angesteuert bzw. mit den Ansteuerleitungen A1 bzw. A2 niederohmig verbunden.

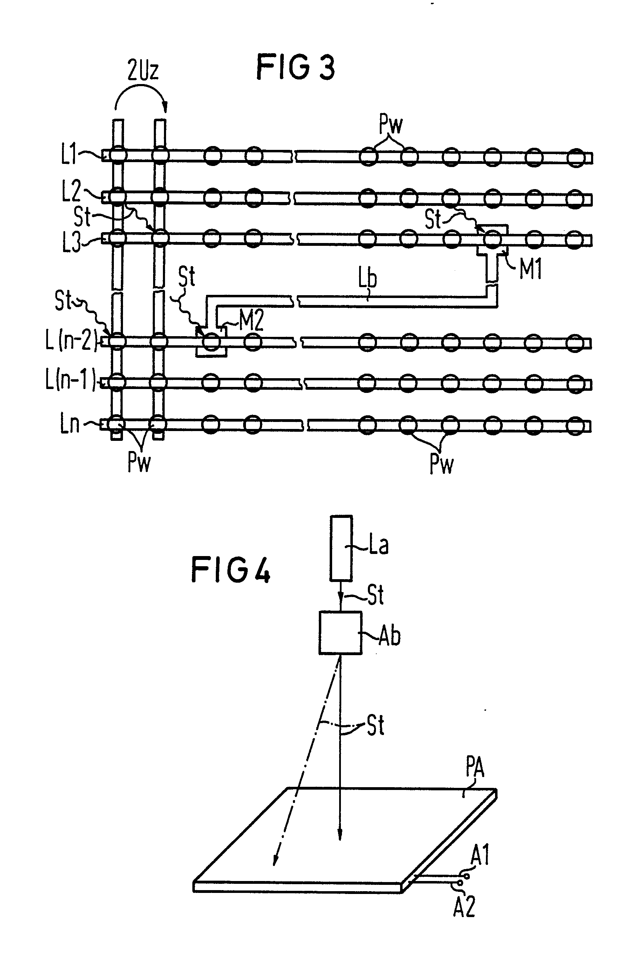

Fig. 3 zeigt die in Fig. 2 im Prinzip dargestellte Einrichtung beim Einsatz für die elektrische Funktionsprüfung von Leiterplatten. Dabei sind die Ansteuerleitungen A1 und A2, die Leitungen L1 und Ln sowie sämtliche Photowiderstände Pw in Dünnfilmtechnik hergestellt. Die Photowiderstände Pw an den Kreuzungsstellen der Ansteuerleitungen A1 und A2 und der Leitungen L1 bis Ln sind als dünne kreisrunde Schichten zu erkennen, die sich auf den Leitungen L1 bis Ln und unter den Ansteuerleitungen A1 bzw. A2 befinden. Alle übrigen Photowiderstände Pw sind ebenfalls als dünne kreisrunde Schichten ausgebildet, die sich jedoch unterhalb der zugeordneten Leitungen L1 bis Ln befinden und jeweils mit der Elektrode eines Gasentladungskanals verbunden sind. Diese Gasentladungskanäle ermöglichen bei der aus der EP-A-0 102 565 bekannten Vorrichtung für die elektrische Funktionsprüfung von Leiterplatten eine ohm'sche Kontaktierung der jeweiligen Meßstelen. Im dargestellten Bei spiel sind dies die Meßstellen M1 und M2 einer Leiterbahn Lb. Werden die vier über den Strahl St seriell mit Licht beaufschlagbaren Photowiderstände Pw niederohmig, so liegt an den Elektroden oberhalb der Meßstellen M1 und M2 die doppelte Zündspannung $2U_z$ an. Ein Zünden der beiden Gasentladungsstrekken bietet dann die Gewähr, daß die Leiterbahn Lb nicht unterbrochen ist.

Fig. 4 zeigt eine perspektivische Gesamtdarstellung der in den Fig. 2 und 3 aufgezeigten Einrichtung. Es ist ein planarer Adapter PA mit beispielsweise 1000 $^\times$ 1000 Rasterpunkten dargestellt, wobei jdem Rasterpunkt ein Photowiderstand Pw gemäß Fig. 2 zugeordnet ist. Den beiden Ansteuerleitungen A1 und A2 sind dann weitere 2000 Photowiderstände Pw zugeordnet. Oberhalb des planaren Adapters PA befindet sich ein Laser La, wie z.B. ein He-Laser oder ein Ne-Laser, dessen Strahl St über einen akusto-optischen Ablenker Ab auf jeden der $10^6$ + 2000 Photowiderstände Pw gerichtet werden kann. Die Ansteuerung mit $10^{12}$ Verbindungsmöglichkeiten benötigt also nur einen ablenkbaren Strahl St und die beiden Ansteuerleitungen A1 und A2.

Bei der in Fig. 3 vereinfacht dargestellten Einrichtung könnten die beiden Meßstellen M1 und M2 dann nicht angesteuert werden, wenn beide einer einzigen der Leitungen L1 bis Ln zugeordnet wären. Aus diesem Grund werden die Leitungen L1 bis Ln tatsächlöich dann so angeordnet, daß sie quer zu den Hauptrichtungen der zu prüfenden Leiterplatte verlaufen. Diese Hauptrichtungen sind in Fig. 3 durch die horizontale und die vertikale Richtung der Leiterbahn Lb aufgezeigt. Verlaufen die Leitungen L1 bis Ln nun beispielsweise unter einem Winkel von 45° zu den Hauptrichtungen der Leiterbahnen Lb, so können durch eine Verdrehung des gesamten planaren Adapters PA (vgl. Fig. 4) um einen Winkel von 90° oder 270° relativ zur Leiterplatte sämtliche Meßstellen sicher erfaßt werden.

Die erfindungsgemäßen Einrichtungen werden vorzugsweise für die elektrische Funktionsprüfung von Verdrahtungsfeldern eingesetzt, bei welcher die Meßstellen ionisch, d.h. über Gasentladungskanäle kontaktiert werden. Die Vorteile der Ansteuereinrichtungen können jedoch auch bei elektrischen Funktionsprüfungen mit konventionellen Nadeladaptern und federnden Prüfspitzen angewandt werden. Weitere Einsatzmöglichkeiten der erfindungsgemäßen Ansteuereinrichtungen sind elektrische Funktionstests von Flachbaugruppen, die Ansteuerung von Displays wie z.B. Gasentladungsdisplays und allgemein die Ansteuerung matrixförmig angeordneter Kontakte.

## Ansprüche

1. Einrichtung zur Ansteuerung mindestens zweier von mehreren Leitungen,
**dadurch gekennzeichnet,**
daß mindestens zwei Ansteuerleitungen (A1, A2) jeweils über einen Photowiderstand (Pw) mit jeder Leitung (L1 bis Ln) verbunden sind und daß jeder Photowiderstand (Pw) steuerbar mit Licht beaufschlagbar ist.

2. Einrichtung zur Ansteuerung mindestens zweier von mehreren rasterförmig angeordneten Kontaktstellen,
**dadurch gekennzeichnet,**
daß die Kontaktstellen (K) reihenweise über jeweils einen zugeordneten Photowiderstand (Pw) mit zugeordneten Leitungen (L1 bis Ln) verbunden sind, daß mindestens zwei Ansteuerleitungen (A1, A2) jeweils über einen Photowiderstand (Pw) mit jeder Leitung (L1 bis Ln) verbunden sind und daß jeder Photowiderstand (Pw) steuerbar mit Licht beaufschlagbar ist.

3. Einrichtung nach Anspruch 1 oder 2,

**dadurch gekennzeichnet,**

daß die Photowiderstände (Pw) aus Cadmiumsulfid oder Cadmiumselenid bestehen.

4. Einrichtung nach einem der vorhergehenden Ansprüche,

**dadurch gekennzeichnet,**

daß die Photowiderstände (Pw) in Dünnfilmtechnik hergestellt sind.

5. Einrichtung nach einem der vorhergehenden Ansprüche,

**dadurch gekennzeichnet,**

daß die Ansteuerleitungen (A1, A2) in Dünnfilmtechnik hergestellt sind.

6. Einrichtung nach einem der vorhergehenden Ansprüche,

**dadurch gekennzeichnet,**

daß die Leitungen (L1 bis Ln) in Dünnfilmtechnik hergestellt sind.

7. Einrichtung nach einem der vorhergehenden Ansprüche,

**dadurch gekennzeichnet,**

daß die Photowiderstände (Pw) über einen ablenkbaren Strahl (St) mit Licht beaufschlagbar sind.

8. Einrichtung nach Anspruch 7,

**dadurch gekennzeichnet,**

daß der Strahl (St) durch einen fokussierbaren Laserstrahl gebildet ist.

9. Einrichtung nach Anspruch 7 oder 8,

**dadurch gekennzeichnet,**

daß zur Ablenkung des Strahls (St) ein akusto-optischer Ablenker (Ab) vorgesehen ist.

10. Einrichtung nach einem der Ansprüche 7 bis 9,

**dadurch gekennzeichnet,**

daß die Photowiderstände (Pw) seriell mit Licht beaufschlagbar sind.

# FIG 1

# FIG 2

# FIG 3

# FIG 4